# EUROPEAN PATENT APPLICATION

(11) **EP 4 636 421 A1**
(43) Date of publication of application: **22.10.2025**
(21) Application number: 23903460.6
(22) Date of filing: 11.12.2023
(51) Int. Cl.: G01R 31/392, G01R 31/367, G01R 31/389, H01M 10/42, H01M 10/48, H02J 7/00

(54) **BATTERY EVALUATION DEVICE, MACHINE LEARNING DEVICE, BATTERY EVALUATION PROGRAM, BATTERY EVALUATION METHOD, MACHINE LEARNING PROGRAM, AND MACHINE LEARNING METHOD**

(30) Priority: 15.12.2022 JP 2022200400; 23.08.2023 JP 2023135297
(71) Applicant: HORIBA, Ltd., Kyoto-shi Kyoto 601-8510 (JP)
(72) Inventor: DING, Li, Kyoto-shi, Kyoto 601-8510 (JP); SAITO, Takashi, Kyoto-shi, Kyoto 601-8510 (JP); YABUSHITA, Hirotaka, Kyoto-shi, Kyoto 601-8510 (JP); HIROSE, Jun, Kyoto-shi, Kyoto 601-8510 (JP)
(74) Representative: Müller Hoffmann & Partner
(86) International application number: PCT/JP2023/044163
(87) International publication number: WO 2024/128174

(57) **Abstract**

The present invention accurately calculates a deterioration state of a battery from EIS data of the battery, and includes: a correlation data storage unit that stores correlation data indicating a correlation between DRT data related to a relaxation time distribution obtained from EIS data of a battery and a deterioration state of the battery; a DRT data acquisition unit that acquires the DRT data of a test battery to be evaluated; and a deterioration state calculation unit that calculates a deterioration state of the test battery based on the DRT data acquired by the DRT data acquisition unit and the correlation data.

## Description

### Technical Field

The present invention relates to a battery evaluation device, a machine learning device, a battery evaluation program, a battery evaluation method, a machine learning program, and a machine learning method.

### Background Art

Evaluating battery life is an important challenge in a wide range of fields, such as battery management systems (BMS) or battery regeneration in electric vehicles. For example, it is also considered that a new battery is used for an automobile, a battery having an electric capacity of less than 80% of the new battery is used for an electric storage business, and a battery having an electric capacity of less than 30% of the new battery is collected to reuse an electrode material, and the use of the battery is cycled to maximize the utilization rate.

As an index for evaluating the life of the battery, a state of health (SOH) or remaining useful life (RUL) of the battery is used. The SOH may be expressed as a ratio of an electrical capacity Capacity_{Now} of a current battery to an electrical capacity Capacity_{New} of a new battery (Capacity_{Now}/Capacity_{New}). In addition, the RUL can be expressed by a ratio (Cycle number_{Now}/Cycle number_{80%Capacity}) of the current number of cycles Cycle number_{Now} of the battery to the number of cycles Cycle number_{80%Capacity} in which the electrical capacity of the battery decreases to 80% of the new one.

Here, the deterioration of the battery is caused by fluctuation of a plurality of impedances (mainly, an increase in resistance value) inside the battery having different deterioration factors. Since the impedance of the battery shows a resistance value and a phase delay that are different for each frequency of the flow-in current (or the voltage to be applied), the impedance is generally interpreted based on a combination (equivalent circuit model) of a plurality of RC circuits. Electrochemical Impedance Spectroscopy (EIS) data is a combination of a frequency to be applied and a value (impedance value) of a real part and an imaginary part of impedance for the frequency.

As a conventional machine learning method of estimating the SOH of the battery using the EIS data, for example, as shown in Non Patent Literature 1, there are a method of using a Nyquist plot image created from the EIS data as an explanatory variable and a method of using a spectrum matrix (matrix including real and imaginary parts of frequency and impedance) as an explanatory variable.

The method using the Nyquist plot image as an explanatory variable has a problem that the feature of the time constant of the internal impedance that has caused degradation cannot be learned because the frequency information corresponding to each impedance value is lost. In addition, since the resistance value of the RC circuit in the equivalent circuit model corresponds to the radius of the arc on the Nyquist plot image, there is a problem that it is difficult to detect a variation of the RC circuit having a relatively small resistance value.

On the other hand, the method using the spectral matrix as an explanatory variable is superior to the method using the Nyquist plot image as an explanatory variable in that information on frequency is also learned. However, since impedance changes due to battery deterioration appear in a wide frequency range, it is difficult to separate measurement noise and impedance changes due to environmental temperature changes at the time of measurement from the measured EIS data and to learn only information due to battery deterioration from limited data, and there is a problem that SOH estimation accuracy is not high.

### Citation List

### Non Patent Literature

Non Patent Literature 1: Yunwei Zhang and 5 others "Identifying degradation patterns of lithium ion batteries from impedance spectroscopy using machine learning", NATURE COMMUNICATIONS volume 11, Article number 1706 (2020), published on 6 April 2020

### Summary of Invention

### Technical Problem

Therefore, the present invention has been made to solve the above problems, and an object thereof is to accurately calculate a deterioration state of a battery.

### Solution to Problem

That is, a battery evaluation device according to the present invention includes: a correlation data storage unit that stores correlation data indicating a correlation between DRT data related to a relaxation time distribution obtained from EIS data of a battery and a deterioration state of the battery; a DRT data acquisition unit that acquires the DRT data of a test battery to be evaluated; and a deterioration state calculation unit that calculates a deterioration state of the test battery based on the DRT data acquired by the DRT data acquisition unit and the correlation data.

In the battery evaluation device, since the deterioration state of the battery is calculated using the correlation data indicating the correlation between the DRT data related to the relaxation time distribution obtained from the EIS data of the battery and the deterioration state of the battery, the deterioration state of the battery can be accurately calculated. That is, in the present invention, the deterioration state of the battery is calculated using the DRT data related to the relaxation time distribution in which the relationship with the deterioration state of the battery is simple, instead of calculating the deterioration state of the battery using the EIS data in which the relationship with the deterioration state of the battery is complicated as it is, so that the deterioration state of the battery can be accurately calculated.

Specifically, the DRT data is a set of a time constant of an RC circuit in an equivalent circuit model and a value corresponding to a resistance component corresponding thereto, and can be learned including a time constant characteristic of impedance unlike the Nyquist plot image. Furthermore, unlike the spectrum matrix, since the resistance component corresponding to each time constant is calculated, even a small resistance change is easily detected if the time constant corresponding to the degradation factor is different. Therefore, the influence of the ambient temperature and the measurement noise can be reduced, and the deterioration state of the battery can be accurately calculated.

As a specific implementation mode of the correlation data, it is desirable that the correlation data is machine-learned using a data set including the DRT data obtained from the EIS data and the deterioration state of the battery.

As an index for evaluating the life of the battery, a state of health (SOH) or remaining useful life (RUL) of the battery is often used. Therefore, it is desirable that the deterioration state in the correlation data is an SOH indicating a state of health or a RUL indicating a remaining useful life of the battery, and the deterioration state calculation unit calculates the SOH or the RUL of the test battery based on the DRT data acquired by the DRT data acquisition unit and the correlation data.

The DRT data has a range in which the accuracy of the relaxation time is poor depending on its frequency range. Therefore, it is desirable that the correlation data indicates a correlation between DRT data for a partial time constant range in the DRT data and a deterioration state of the battery.

With this configuration, it is possible to make the correlation data highly accurate to accurately calculate the deterioration state of the battery. For example, it is conceivable to create correlation data by removing data in a low time constant range of 0.1 Hz and using relaxation times in other time constant ranges.

Specifically, it is desirable that the correlation data indicates a correlation between a peak intensity, a peak intensity ratio, a peak position, or a peak width of a DRT spectrum included in the DRT data and the deterioration state of the battery.

As a specific embodiment of the DRT data acquisition unit, it is desirable that the DRT data acquisition unit includes an EIS data calculation unit that calculates the EIS data of the test battery, and a DRT data calculation unit that calculates the DRT data from the EIS data calculated by the EIS data calculation unit.

The DRT data acquisition unit may include a DRT data calculation unit that acquires externally calculated EIS data and calculates DRT data from the acquired EIS data. Alternatively, the DRT data acquisition unit may acquire DRT data calculated externally.

Specifically, it is desirable that the EIS data calculation unit calculates the EIS data based on an alternating signal input to the test battery and a response signal of the test battery measured at that time.

Preferably, the DRT data acquisition unit further includes an alternating signal input unit that inputs an alternating signal to the test battery, and a response signal measurement unit that measures a response signal of the test battery.

It is desirable that the battery evaluation device according to the present invention further includes a parameter calculation unit that calculates a parameter indicating an equivalent circuit model of the battery from the DRT data acquired by the DRT data acquisition unit.

With this configuration, it is possible to analyze the lifetime of the battery by associating the parameter calculated by the parameter calculation unit with the deterioration information calculated by the deterioration information calculation unit.

In addition, a machine learning device according to the present invention generates a machine learning model used in a battery evaluation device, the machine learning device performing machine learning on a data set including DRT data regarding a relaxation time distribution obtained from EIS data of a battery and a deterioration state of the battery to generate a machine learning model indicating a correlation between the DRT data and the deterioration state of the battery.

In addition, a battery evaluation device according to the present invention causes a computer to have: a function as a correlation data storage unit that stores correlation data indicating a correlation between DRT data related to a relaxation time distribution obtained from EIS data of a battery and a deterioration state of the battery; a function as a DRT data acquisition unit that acquires the DRT data of a test battery to be evaluated; and a function as a deterioration state calculation unit that calculates a deterioration state of the test battery based on the DRT data acquired by the DRT data acquisition unit and the correlation data.

Note that the battery evaluation program may be distributed electronically or may be recorded in a program recording medium such as a CD, a DVD, or a flash memory.

In addition, a battery evaluation device according to the present invention includes: acquiring correlation data indicating a correlation between DRT data related to a relaxation time distribution obtained from EIS data of a battery and a deterioration state of the battery; acquiring the DRT data of a test battery to be evaluated; and calculating a deterioration state of the test battery based on the DRT data and the correlation data acquired.

Note that the battery evaluation program may be distributed electronically or may be recorded in a program recording medium such as a CD, a DVD, or a flash memory.

In addition, a machine learning program according to the present invention generates a machine learning model used in a battery evaluation device, the machine learning program causing a computer to have a function of performing machine learning on a data set including DRT data regarding a relaxation time distribution obtained from EIS data of a battery and a deterioration state of the battery to generate a machine learning model indicating a correlation between the DRT data and the deterioration state of the battery.

In addition, a machine learning method is for generating a machine learning model used in a battery evaluation device, the machine learning method including performing machine learning on a data set including DRT data regarding a relaxation time distribution obtained from EIS data of a battery and a deterioration state of the battery to generate a machine learning model indicating a correlation between the DRT data and the deterioration state of the battery. Advantageous Effects of Invention

According to the present invention thus configured, a deterioration state of a battery can be accurately calculated from EIS data of the battery.

### Brief Description of Drawings

FIG. 1 is a diagram schematically illustrating a configuration of a battery evaluation device according to an embodiment of the present invention.
FIG. 2 is a functional block diagram of the arithmetic device of the embodiment.
FIG. 3 (a) is a diagram illustrating EIS data, and FIG. 3 (b) is a diagram illustrating DRT data.
FIG. 4 is a functional block diagram of the machine learning device according to the embodiment.
FIG. 5 is a flowchart illustrating a machine learning method and a battery evaluation method according to the embodiment.
FIG. 6 (a) is a simulation result of a conventional example (a machine learning model using EIS data), and FIG. 6 (b) is a simulation result of the present embodiment (a machine learning model using DRT data).
FIG. 7 is a functional block diagram of an arithmetic device according to a modified embodiment.

### Description of Embodiments

Hereinafter, an embodiment of a battery evaluation device according to the present invention will be described with reference to the drawings.

Note that any of the drawings shown below is schematic, and omitted or exaggerated as appropriate for easy understanding. The same constituent elements are denoted by the same reference numerals, and the description thereof will be omitted as appropriate.

### < Basic configuration of battery evaluation device 100 >

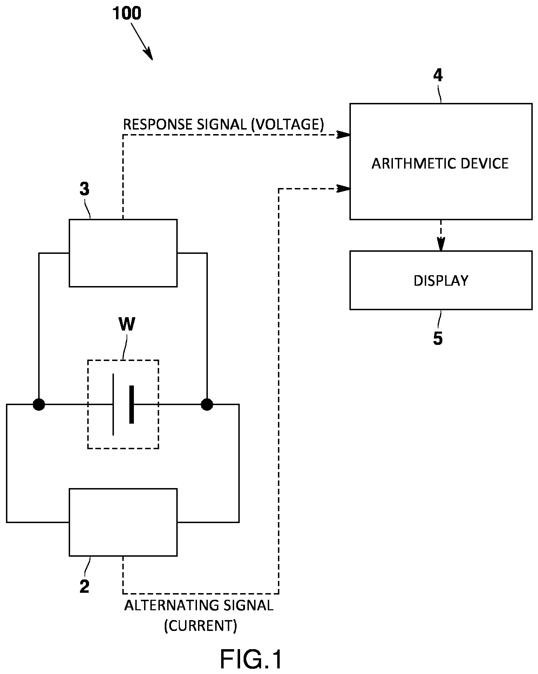

As illustrated in FIG. 1, a battery evaluation device 100 of the present embodiment includes a current input unit 2 that inputs a predetermined current to a test battery W (hereinafter, simply referred to as the sample W) to be evaluated, a voltage detection unit 3 that detects an output voltage V(t) of an output terminal of the sample W, and an arithmetic device 4 that calculates deterioration information of the sample W based on an input current I(t) and the output voltage V(t) of the sample W.

The current input unit 2 can control the input current I(t) input to the sample W. The current input unit 2 can also adjust the frequency of the input current I(t) input to the sample W. Further, the current input unit 2 can charge and discharge the sample W. The battery evaluation device 100 may include an alternating signal input unit that inputs an alternating signal (current or voltage) to the sample W instead of the current input unit 2.

The voltage detection unit 3 detects the output voltage V(t) when the input current I(t) is input by the current input unit 2. The current input unit 2 and the voltage detection unit 3 are used for electrochemical impedance spectroscopy (EIS) measurement. The battery evaluation device 100 may include a response signal measurement unit that measures a response signal of the sample W instead of the voltage detection unit 3.

In the EIS measurement, an alternating signal (voltage or current) is input to the battery, and a response signal (current or voltage) of the battery is measured to obtain EIS data such as impedance from a ratio (current/voltage) of these signals.

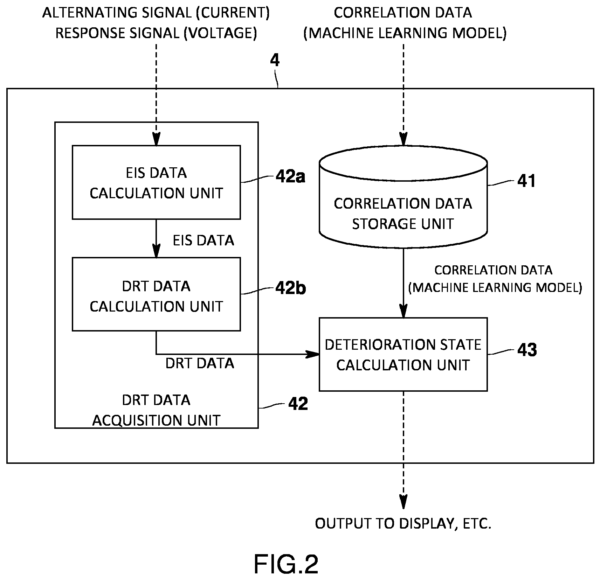

As illustrated in FIG. 2, the arithmetic device 4 includes a correlation data storage unit 41 that stores correlation data indicating a correlation between data (hereinafter, DRT data) related to a relaxation time distribution obtained from EIS data of the battery and a deterioration state of the battery, a DRT data acquisition unit 42 that acquires DRT data of the sample W, and a deterioration state calculation unit 43 that calculates a deterioration state of the sample W on the basis of the DRT data acquired by the DRT data acquisition unit 42 and the correlation data.

Note that the arithmetic device 4 includes a computer including a CPU, a memory, an input/output interface, an AD converter, a display device 5 such as a display, and the like. Then, the arithmetic device 4 exerts the function of each unit 41-43 by the CPU and the peripheral device cooperating on the basis of the battery evaluation program stored in the memory. Note that the arithmetic device 4 may be configured by a physically integrated computer, or may be configured by physically separate computers.

Each of the units 41-43 will be described below.

The correlation data storage unit 41 stores correlation data indicating a correlation between DRT data related to a relaxation time distribution obtained from EIS data of a battery and a deterioration state of the battery.

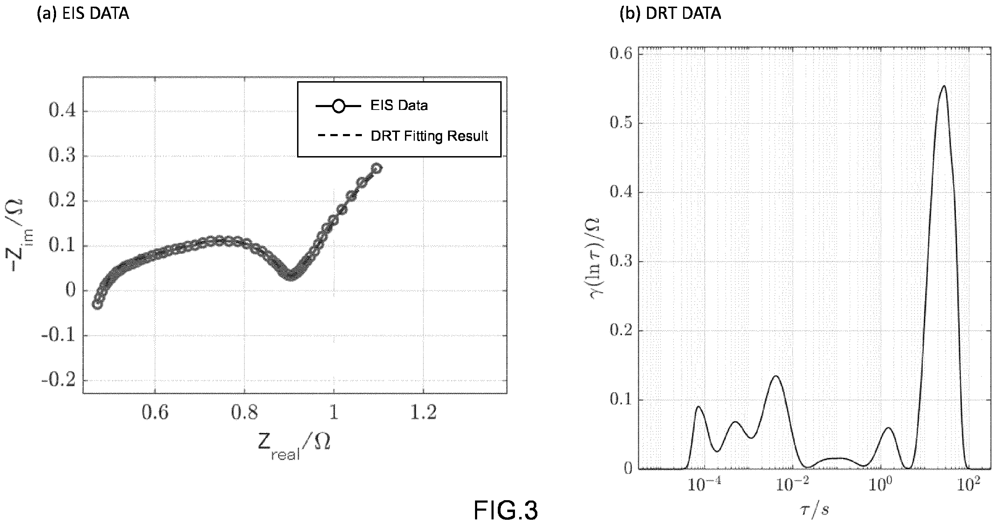

Here, the EIS data is data obtained by EIS measurement, and is complex impedance of an electrochemical system obtained by discrete Fourier transform of a response signal of a battery when an alternating signal is input to the battery. As illustrated in FIG. 3 (a), the EIS data is, for example, an EIS spectrum that can be expressed by a graph in which the horizontal axis is the real part of the complex impedance and the vertical axis is the imaginary part of the complex impedance.

In addition, the DRT data is a relaxation time distribution (this is also referred to as a DRT spectrum) obtained by performing DRT conversion on the EIS data which is a frequency field, and as illustrated in FIG. 3 (b), for example, the DRT data can be represented by a graph in which a horizontal axis is a relaxation time (time constant) and a vertical axis is a value corresponding to impedance.

The correlation data is machine-learned using a data set including the DRT data obtained from the EIS data and the deterioration state of the battery. In addition, the deterioration state in the correlation data is a state of health (hereinafter referred to as SOH) or a remaining useful life (hereinafter referred to as RUL) of the battery. Furthermore, the correlation data may indicate a correlation between DRT data for a partial time constant range in the DRT data and a deterioration state of the battery. For example, it is conceivable to create correlation data by removing data in a low time constant range of 0.1 Hz and using relaxation times in other time constant ranges.

Furthermore, the correlation data may be data indicating a correlation between: feature data indicating a feature (for example, a peak intensity (peak height), a peak position, a peak intensity ratio, a peak width, or the like) of the DRT spectrum included in the DRT data; and a deterioration state of the battery. Furthermore, the correlation data may be data indicating a correlation between a parameter (DC resistance R₀, inductor L, resistor R, CPE constant (pseudo capacitance) Q, CPE coefficient α, or the like) indicating an equivalent circuit model of the battery obtained from the DRT data and a deterioration state of the battery. The equivalent circuit model is a circuit model in which a plurality of parallel circuits including a resistor R and a constant-phase element (CPE; pseudo capacitance, a virtual component having characteristics of both a capacitor and a resistor) and a DC resistor R₀, and an inductor L are connected in series.

The DRT data acquisition unit 42 acquires the DRT data of the sample W, and in the present embodiment, includes an EIS data calculation unit 42a that calculates the EIS data of the sample W, and a DRT data calculation unit 42b that calculates the DRT data from the EIS data calculated by the EIS data calculation unit 42a. The DRT data acquisition unit 42 may include an alternating signal input unit and/or a response signal measurement unit.

The EIS data calculation unit 42a calculates EIS data on the basis of an input current I(t) that is an alternating signal input by the current input unit 2 and an output voltage V(t) that is a response signal detected by the voltage detection unit 3.

Here, the acquisition timing of the EIS data (the timing of the EIS measurement) will be described.

First, the sample W is placed in a thermostatic bath at a predetermined temperature, and constant current (CC) charging and constant voltage (CV) charging are performed. The constant current is, for example, 1 C. Here, 1 C is a magnitude of a current for fully charging the theoretical capacity of the battery in one hour, and is, for example, a speed of 1 A with respect to a battery of 1 Ah. Thereafter, the sample W is placed in an environment of a predetermined temperature (for example, 25°C) from the completion of charging to be in a steady state, the temperature of the battery is set to the predetermined temperature, and EIS measurement is performed to acquire EIS data. The battery may not be placed in the thermostatic bath.

The DRT data calculation unit 42b calculates the DRT data by converting the EIS data calculated by the EIS data calculation unit 42a by DRT conversion using a radial basis function (RBF) such as a Gaussian function as a kernel function.

The deterioration state calculation unit 43 calculates the SOH or the RUL which is a deterioration state of the battery on the basis of the DRT data calculated by the DRT data calculation unit 42b and the correlation data.

Here, in a case where the correlation data is data indicating the correlation between the characteristic data indicating the characteristic (for example, peak intensity, peak intensity ratio, peak position, peak width, or the like) of the spectrum of the DRT data and the deterioration state of the battery, the deterioration state calculation unit 43 extracts the characteristic of the spectrum from the DRT data and calculates the SOH or the RUL which is the deterioration state of the battery on the basis of the extracted characteristic data and the correlation data.

Further, when the correlation data is data indicating a correlation between a parameter (DC resistance R₀, inductor L, resistor R, CPE constant (pseudo capacitance) Q, CPE coefficient α, or the like) indicating an equivalent circuit model of the battery obtained from the DRT data and a deterioration state of the battery, the deterioration state calculation unit 43 calculates a parameter (DC resistance R₀, inductor L, resistor R, CPE constant (pseudo capacitance) Q, CPE coefficient α, or the like) from the DRT data and calculates the SOH or the RUL which is a deterioration state of the battery on the basis of the calculated parameter and correlation data. As the parameter (DC resistance R₀, inductor L, resistor R, CPE constant (pseudo capacitance) Q, CPE coefficient α, or the like), the subpeaks decomposed using the transfer function of the equivalent circuit model are fitted to calculate the parameters R₀, L, R, Q, and α of the equivalent circuit model.

### < Machine learning device 10 >

The machine learning model that is the correlation data described above is generated by the machine learning device 10 described below.

The machine learning device 10 generates a machine learning model used in a battery evaluation device 100, the machine learning device performing machine learning on a data set including DRT data obtained from EIS data of a battery and a deterioration state of the battery to generate a machine learning model indicating a correlation between the DRT data and the deterioration state of the battery.

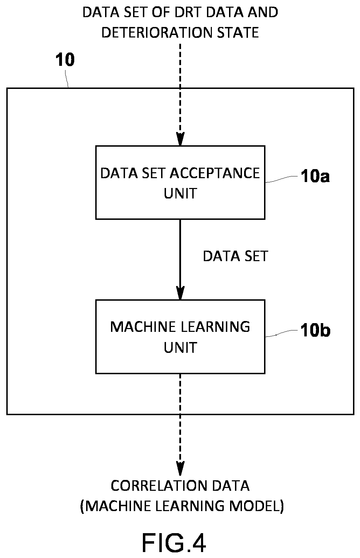

Specifically, as illustrated in FIG. 4, the machine learning device 10 includes a data set acceptance unit 10a that accepts a data set including the DRT data and a deterioration state of a battery, and a machine learning unit 10b that performs machine learning on the data set received by the data set acceptance unit 10a and generates a machine learning model indicating a correlation between the DRT data and the deterioration state of the battery.

The data set acceptance unit 10a receives, for example, a data set including a plurality of pieces of DRT data and deterioration states obtained using batteries of different temperatures or different deterioration states.

The machine learning unit 10b may extract a feature of the spectrum of the DRT data (for example, a peak intensity or a peak position, a peak intensity ratio, a peak width, or the like), to generate a machine learning model indicating a correlation between the extracted feature data and the deterioration state of the battery. Furthermore, the machine learning unit may calculate a parameter (DC resistance R₀, inductor L, resistor R, CPE constant (pseudo capacitance) Q, CPE coefficient α, or the like) indicating an equivalent circuit model of the battery from the DRT data, to generate a machine learning model indicating a correlation between the calculated parameter and a deterioration state of the battery.

### < Machine learning method and battery evaluation method >

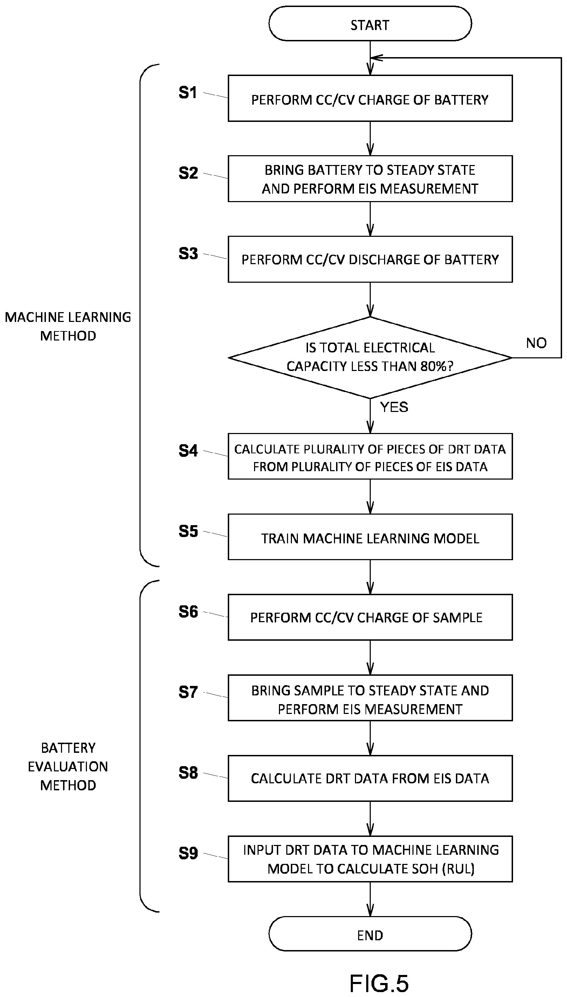

A machine learning method and a battery evaluation method using the machine learning device and the battery evaluation device according to the present embodiment will be described with reference to FIG. 5. In the following description, the machine learning method and the battery evaluation method are continuously performed, but may be separately performed.

First, the battery is placed in a thermostatic bath at a predetermined temperature, and constant current (CC) charging and constant voltage (CV) charging are performed (step S1). Note that this CC/CV charging can be performed by a control unit (not illustrated) controlling a charge/discharge device such as the current input unit 2.

Thereafter, the sample W is placed in an environment of a predetermined temperature (for example, 25°C) from the completion of charging to be in a steady state, the temperature of the battery is set to the predetermined temperature, and EIS measurement is performed to acquire EIS data (step S2). Note that this EIS measurement is performed by a control unit (not illustrated) controlling a charge/discharge device such as the current input unit 2.

Subsequently, constant current (CC) discharge or constant voltage (CV) discharge is performed, and the electrical capacity (battery capacity) output from the battery in this discharging process is measured (step S3). Note that this CC/CV discharge is performed by a control unit (not illustrated) controlling a charge/discharge device such as the current input unit 2.

Steps S1 to S3 are repeated to acquire EIS data until the electric capacity output from the battery in the discharge step becomes a predetermined ratio (for example, 80%) or less of the value at the first measurement.

Next, a plurality of pieces of DRT data are calculated by performing DRT conversion on the acquired plurality of pieces of EIS data (step S4).

Then, the DRT data and the battery capacity data (SOH or RUL) are input to a machine learning model having initial setting prepared in advance in the machine learning device 10 as an explanatory variable and a target variable, respectively. The machine learning device 10 trains the machine learning model based on the input DRT data and battery capacity data (SOH or RUL) (step S5). As described above, the machine learning device 10 generates the machine learning model indicating the correlation between the DRT data and the deterioration state of the battery.

Next, the sample W is placed in a thermostatic bath at a predetermined temperature, and constant current (CC) charging and constant voltage (CV) charging are performed (step S6). Note that this CC/CV charging can be performed by a control unit (not illustrated) controlling a charge/discharge device such as the current input unit 2.

Thereafter, the sample W is placed in an environment of a predetermined temperature (for example, 25°C) from the completion of charging to be in a steady state, the temperature of the battery is set to the predetermined temperature, and EIS measurement is performed. The EIS data calculation unit 42a acquires the EIS data (step S7). Note that this EIS measurement is performed by a control unit (not illustrated) controlling such as the current input unit 2.

Next, the DRT data calculation unit 42b performs DRT conversion on the acquired EIS data of the sample W to calculate the DRT data of the sample W (step S8).

Then, the deterioration state calculation unit 43 inputs the calculated DRT data of the sample W to the machine learning model, to calculate a predicted value of the SOH or RUL of the sample W (step S9). This prediction value is displayed (output) on the display device 5 such as a display.

### < Effects of present embodiment >

According to the battery evaluation device 100 according to the present embodiment, since the deterioration state of the battery is calculated using the correlation data indicating the correlation between the DRT data obtained from the EIS data of the battery and the deterioration state of the battery, the deterioration state of the battery can be accurately calculated. That is, in the present invention, the deterioration state of the battery is calculated using the DRT data having a simple relationship with the deterioration state of the battery, instead of calculating the deterioration state of the battery using the EIS data having a complicated relationship with the deterioration state of the battery as it is, so that the deterioration state of the battery can be accurately calculated. Specifically, the DRT data is a set of a time constant of an RC circuit in an equivalent circuit model and a value corresponding to a resistance component corresponding thereto, and can be learned including a time constant characteristic of impedance unlike the Nyquist plot image. Furthermore, unlike the spectrum matrix, since the resistance component corresponding to each time constant is calculated, even a small resistance change is easily detected if the time constant corresponding to the degradation factor is different. Therefore, the influence of the ambient temperature and the measurement noise can be reduced, and the deterioration state of the battery can be accurately calculated.

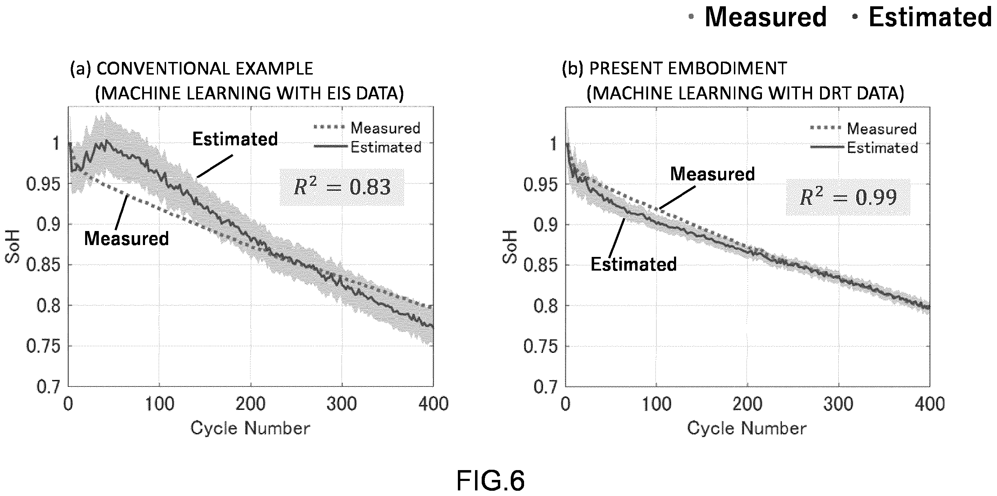

Here, FIG. 6 illustrates an SOH prediction result using a machine learning model (conventional example) subjected to machine learning by EIS data and an SOH prediction result using a machine learning model (present embodiment) subjected to machine learning by DRT data. From these results, it can be seen that the deterioration state of the battery can be accurately calculated by calculating the deterioration state of the battery using the DRT data as in the present embodiment.

### < Modified embodiment of present invention >

Note that the present invention is not limited to the above embodiments.

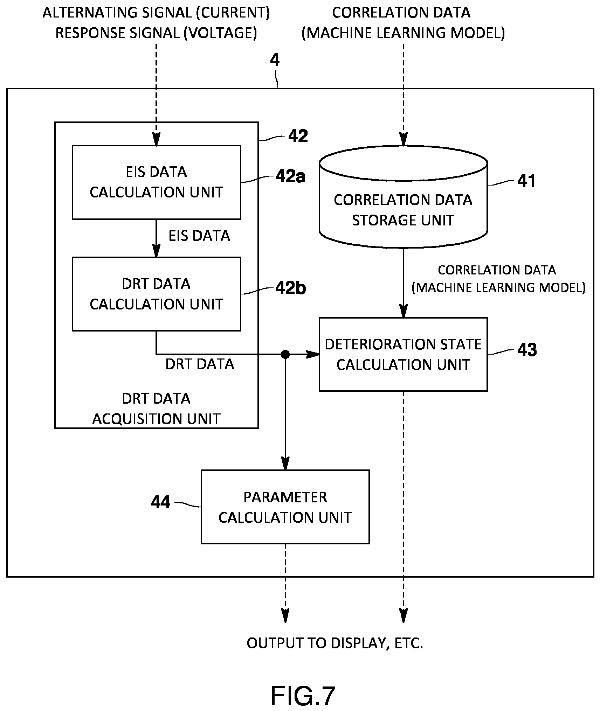

For example, as illustrated in FIG. 7, the battery evaluation device 100 may include a parameter calculation unit 44 that calculates a parameter (DC resistance R₀, inductor L, resistor R, CPE constant (pseudo capacitance) Q, CPE coefficient α, or the like) indicating an equivalent circuit model of the battery from the DRT data acquired by the DRT data acquisition unit 42, separately from the deterioration state calculation unit 43. By calculating the parameter (DC resistance R₀, inductor L, resistor R, CPE constant (pseudo capacitance) Q, CPE coefficient α, or the like) indicating the equivalent circuit model in this manner, it is possible to use the parameter for analyzing the internal change of the battery and to analyze the life of the battery.

In addition, the correction process may be performed in consideration of the test environment or the installation environment (temperature, humidity, atmospheric pressure, and the like) of the battery (sample W) to be evaluated. For example, on the basis of the difference between the acquisition environment of the data set used for the machine learning and the test environment or the installation environment of the sample W, the deterioration state obtained by the deterioration state calculation unit 43 or correction such as multiplying or adding a coefficient to the machine learning model may be performed.

In addition, the data set used for the machine learning may be acquired under conditions in which the ambient environment (for example, temperature, humidity, atmospheric pressure, or the like) of the battery is different, in addition to those acquired under different temperatures and different deterioration states of the battery.

Furthermore, the machine learning device 10 may have a configuration including an EIS data calculation unit that calculates EIS data, a configuration including a DRT data calculation unit that calculates DRT data from EIS data, or a configuration including a data set generation unit that generates a data set including DRT data and a deterioration state.

An M-sequence signal may be used as the alternating signal input in the EIS measurement in the battery evaluation method or the machine learning method of the embodiment. In this case, the charge/discharge device such as the current input unit 2 includes an M-sequence signal generation unit. The M-sequence signal generation unit measures one M sequence or while dividing into a plurality of M sequences in accordance with the set measurement frequency range. In the case of dividing into a plurality of M sequences, the frequency range is divided from the lower limit of the set frequency to the upper limit of the frequency range every 1000 times. For example, in a case where the measurement frequency range is 1 mHz to 10 kHz, it is conceivable to divide into three M-sequence signals: 1 mHz to 1 Hz; 1 Hz to 1 kHz; and 1 kHz to 10 kHz, respectively. By using the M-sequence signal in this manner, it is possible to shorten the time for EIS measurement to a large extent (about 1/4) as compared with the case of measuring the impedance using the alternating signal that is a single sine wave.

In addition, the present invention is not limited to the above embodiment, and it goes without saying that various modifications can be made without departing from the gist of the present invention.

### Industrial Applicability

According to the present invention, it is possible to accurately calculate a deterioration state of a battery from EIS data of the battery.

### Reference Signs List

- 100: battery evaluation device
- W: sample
- 41: correlation data storage unit
- 42: DRT data acquisition unit
- 43: deterioration state calculation unit
- 42a: EIS data calculation unit
- 42b: DRT data calculation unit
- 44: parameter calculation unit
- 10: machine learning device

## Claims

1. A battery evaluation device comprising:
a correlation data storage unit that stores correlation data indicating a correlation between DRT data related to a relaxation time distribution obtained from EIS data of a battery and a deterioration state of the battery;
a DRT data acquisition unit that acquires the DRT data of a test battery to be evaluated;
and
a deterioration state calculation unit that calculates a deterioration state of the test battery based on the DRT data acquired by the DRT data acquisition unit and the correlation data.

2. The battery evaluation device according to claim 1, wherein the correlation data is machine-learned using a data set including the DRT data obtained from the EIS data and the deterioration state of the battery.

3. The battery evaluation device according to claim 1 or 2, wherein
the deterioration state in the correlation data is an SOH indicating a state of health or a RUL indicating a remaining useful life of the battery, and
the deterioration state calculation unit calculates the SOH or the RUL of the test battery based on the DRT data acquired by the DRT data acquisition unit and the correlation data.

4. The battery evaluation device according to any one of claims 1 to 3, wherein the correlation data indicates a correlation between DRT data for a partial time constant range and the deterioration state of the battery.

5. The battery evaluation device according to any one of claims 1 to 4, wherein the correlation data indicates a correlation between a peak intensity, a peak intensity ratio, a peak position, or a peak width of a DRT spectrum included in the DRT data and the deterioration state of the battery.

6. The battery evaluation device according to any one of claims 1 to 5, wherein the DRT data acquisition unit includes:
an EIS data calculation unit that calculates the EIS data of the test battery; and
a DRT data calculation unit that calculates the DRT data from the EIS data calculated by the EIS data calculation unit.

7. The battery evaluation device according to claim 6, wherein the EIS data calculation unit calculates the EIS data based on an alternating signal input to the test battery and a response signal of the test battery measured at that time.

8. The battery evaluation device according to any one of claims 1 to 7, wherein the DRT data acquisition unit further includes:
an alternating signal input unit that inputs an alternating signal to the test battery; and
a response signal measurement unit that measures a response signal of the test battery.

9. The battery evaluation device according to any one of claims 1 to 8, further comprising a parameter calculation unit that calculates a parameter indicating an equivalent circuit model of the battery from the DRT data acquired by the DRT data acquisition unit.

10. A machine learning device that generates a machine learning model used in a battery evaluation device, the machine learning device performing machine learning on a data set including DRT data regarding a relaxation time distribution obtained from EIS data of a battery and a deterioration state of the battery, to generate a machine learning model indicating a correlation between the DRT data and the deterioration state of the battery.

11. A battery evaluation program that causes a computer to have:
a function as a correlation data storage unit that stores correlation data indicating a correlation between DRT data related to a relaxation time distribution obtained from EIS data of a battery and a deterioration state of the battery;
a function as a DRT data acquisition unit that acquires the DRT data of a battery to be evaluated; and
a function as a deterioration state calculation unit that calculates the deterioration state of the battery based on the DRT data acquired by the DRT data acquisition unit and the correlation data.

12. A battery evaluation method comprising:
acquiring correlation data indicating a correlation between DRT data related to a relaxation time distribution obtained from EIS data of a battery and a deterioration state of the battery;
acquiring the DRT data of a battery to be evaluated; and
calculating a deterioration state of the battery based on the DRT data and the correlation data acquired.

13. A machine learning program that generates a machine learning model used in a battery evaluation device,
the machine learning program causing a computer to have a function of performing machine learning on a data set including DRT data regarding a relaxation time distribution obtained from EIS data of a battery and a deterioration state of the battery to generate a machine learning model indicating a correlation between the DRT data and the deterioration state of the battery.

14. A machine learning method for generating a machine learning model used in a battery evaluation device,
the machine learning method comprising performing machine learning on a data set including DRT data regarding a relaxation time distribution obtained from EIS data of a battery and a deterioration state of the battery to generate a machine learning model indicating a correlation between the DRT data and the deterioration state of the battery.
